# EUROPÄISCHE PATENTANMELDUNG

(11) **EP 1 898 685 A1**
(43) Veröffentlichungstag der Anmeldung: **12.03.2008**
(21) Anmeldenummer: 07011893.0
(22) Anmeldetag: 18.06.2007
(51) Int. Cl.: H05K 7/20

(54) **Lüfter**

(30) Priorität: 05.09.2006 DE 202006013982 U
(71) Anmelder: ebm-papst St. Georgen GmbH & Co. KG, 78112 St. Georgen (DE)
(72) Erfinder: Seidler, Siegfried, Dipl.-Ing., 78056 Villingen-Schwenningen (DE)
(74) Vertreter: Raible, Tobias

(57) **Zusammenfassung**

Ein Lüfter (44) hat ein Lüftergehäuse mit einer Lufteintrittsöffnung und einer Luftauftrittsöffnung. Im Bereich der Luftauftrittsöffnung ist ein Nachleitelement (30) vorgesehen, das dazu ausgebildet ist, den Drall der im Betrieb aus dem Lüfter (44) austretenden Luft mindestens teilweise in statischen Druck umzusetzen. Dieses Nachleitelement hat mindestens eine Luftdurchtrittsöffnung und ist an der Ausströmseite dieser Luftdurchtrittsöffnung mit mindestens einer Rückschlagklappe (72, 74, 76, 78) versehen, welche in ihrer Schließstellung die Luftdurchtrittsöffnung mindestens teilweise verschließt.

## Beschreibung

Die Erfindung betrifft einen Lüfter nach Art eines Axial- oder Diagonallüfters.

Zur Kühlung von elektronischen Geräten werden häufig mehrere Lüfter in einem Einschub oder dergleichen parallel betrieben, z.B. in einem sogenannten Rack für Server, oder im Schaltschrank einer Mobilfunkstation. Die Verwendung mehrerer Lüfter dient dabei zur Erzeugung einer Redundanz, d.h. wenn einer der Lüfter ausfällt, stellen der oder die restlichen Lüfter sicher, dass weiterhin genügend Kühlluft zur Verfügung steht.

Wenn in einem Einschub einer der Lüfter ausfällt und die anderen Lüfter weiterlaufen, würde die Luft im Kurzschluss durch den stehenden Lüfter zirkulieren, und diese Kurzschlussströmung muss deshalb minimiert werden. Hierzu verwendet man Rückschlagklappen, welche sich automatisch schließen, wenn die Luft in die falsche Richtung strömt. Ein Beispiel hierfür zeigt die US 6 174 232 B1, und dort ist auch das Problem beschrieben, dass die verwendeten Rückschlagklappen einen zusätzlichen Strömungswiderstand darstellen und folglich die Lüfterleistung reduzieren.

Es ist folglich eine Aufgabe der Erfindung, einen neuen Lüfter bereit zu stellen.

Nach der Erfindung wird diese Aufgabe gelöst durch einen Lüfter gemäß Anspruch 1. Durch die Verwendung eines Nachleitelements, wie es im Prinzip aus der US 6 017 191 der Anmelderin bekannt ist, wird ein Teil des Druckverlusts, der durch die mindestens eine Rückschlagklappe verursacht wird, ausgeglichen, weil das Nachleitelement einen zusätzlichen statischen Druck aufbaut. Auch bewirkt das Nachleitelement, dass der Drall der Luftströmung reduziert wird, welche aus dem Nachleitelement ausströmt. Dieser Drall könnte die Rückschlagklappe(n) zum Klappern oder Flattern bringen, und dieser Effekt wird durch das Nachleitelement reduziert, so dass ein Lüftereinschub mit solchen verbesserten Lüftern ruhiger arbeitet, weil die Rückschlagklappen drallarm angeströmt werden, wobei zusätzlich der Wirkungsgrad verbessert wird.

Weitere Einzelheiten und vorteilhafte Weiterbildungen der Erfindung ergeben sich aus den im Folgenden beschriebenen und in der Zeichnung dargestellten, in keiner Weise als Einschränkung der Erfindung zu verstehenden Ausführungsbeispielen, sowie aus den Unteransprüchen. Es zeigt:
- Fig. 1: eine perspektivische Draufsicht auf ein Nachleitelement, gesehen von seiner Luftzuströmseite und bei geschlossenen Rückschlagklappen,
- Fig. 2: das Nachleitelement der Fig. 1, gesehen von seiner Luftausströmseite, ebenfalls bei geschlossenen Rückschlagklappen,
- Fig. 3: eine vergrößerte Darstellung einer der vier Rückschlagklappen,
- Fig. 4: eine Darstellung des Nachleitelements analog Fig. 2, aber bei geöffneten Rückschlagklappen,

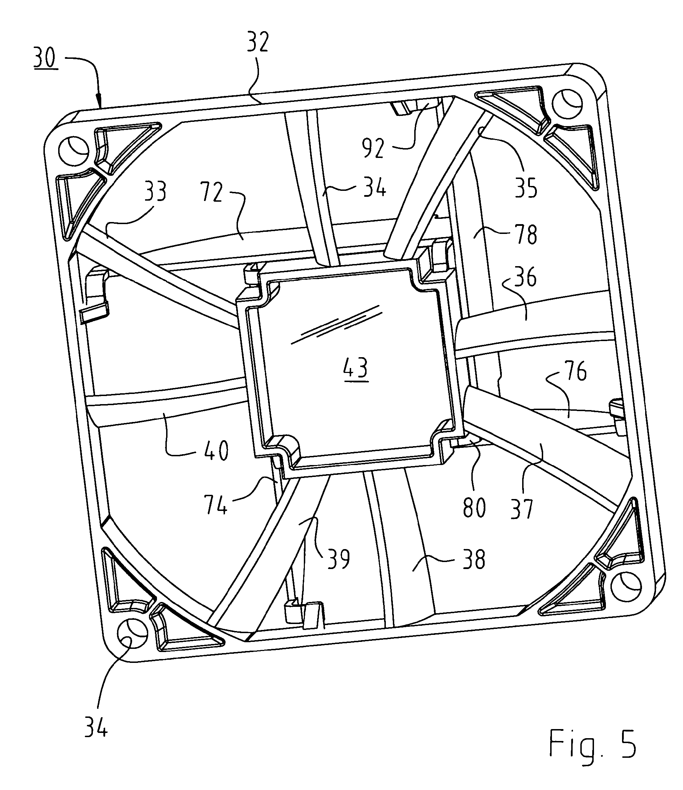

- Fig. 5: das Nachleitelement der Fig. 4, gesehen von seiner Luftzuströmseite, und bei geöffneten Rückschlagklappen,

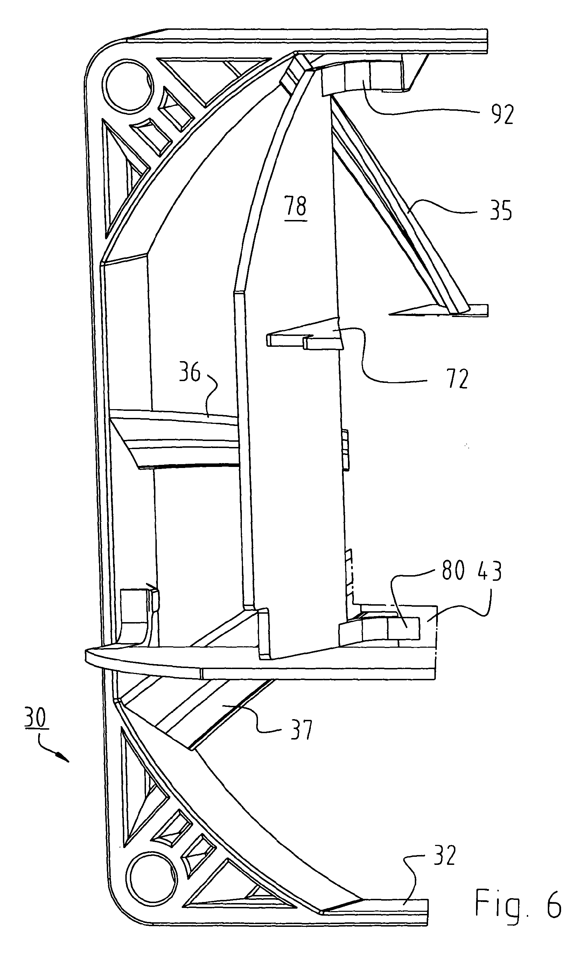

- Fig. 6: eine vergrößerte Darstellung analog Fig. 4, und bei geöffneten Rückschlagklappen,

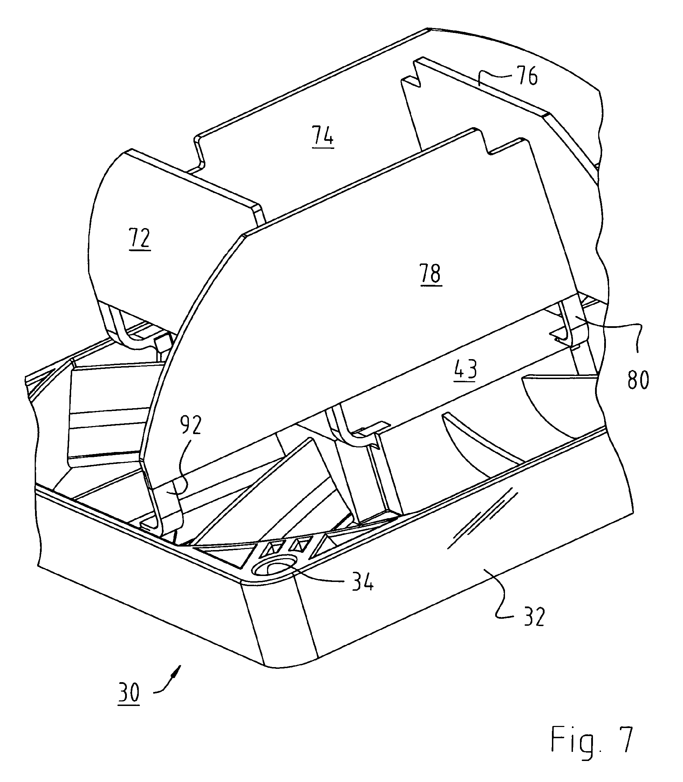

- Fig. 7: eine perspektivische Darstellung analog den Fig. 4 bis 6, welche die vier Rückschlagklappen im geöffneten Zustand zeigt,
- Fig. 8: einen Gerätelüfter (Axial- oder Diagonallüfter), auf dessen Ausströmseite ein Nachleitelement gemäß Fig. 1 bis 7 angebracht ist, bei geschlossenen Rückschlagklappen,
- Fig. 9: eine Darstellung analog Fig. 8, aber bei geöffneten Rückschlagklappen,
- Fig. 10: eine Draufsicht analog Fig. 8 auf die Kombination eines Gerätelüfters und eines Nachleitelements, bei geschlossenen Rückschlagklappen,
- Fig. 11: einen Schnitt durch ein Anlenkglied einer geschlossenen Klappe, gesehen längs der Linie XI-XI der Fig. 10,

- Fig. 12: einen Schnitt, gesehen längs der Linie XII-XII der Fig. 10,
- Fig. 13: einen Schnitt, gesehen längs der Linie XIII-XIII der Fig. 10,
- Fig. 14: einen Schnitt, gesehen längs der Linie XIV-XIV der Fig. 10,
- Fig. 15: eine Draufsicht analog Fig. 9 auf die Kombination eines Gerätelüfters und eines Nachleitelements, bei geöffneten Rückschlagklappen,
- Fig. 16: einen Schnitt durch ein Anlenkglied einer geöffneten Klappe, gesehen längs der Linie XVI-XVI der Fig. 15,
- Fig. 17: einen Schnitt, gesehen längs der Linie XVII-XVII der Fig. 15, und
- Fig. 18: einen Schnitt, gesehen längs der Linie XVIII-XVIII der Fig. 15.

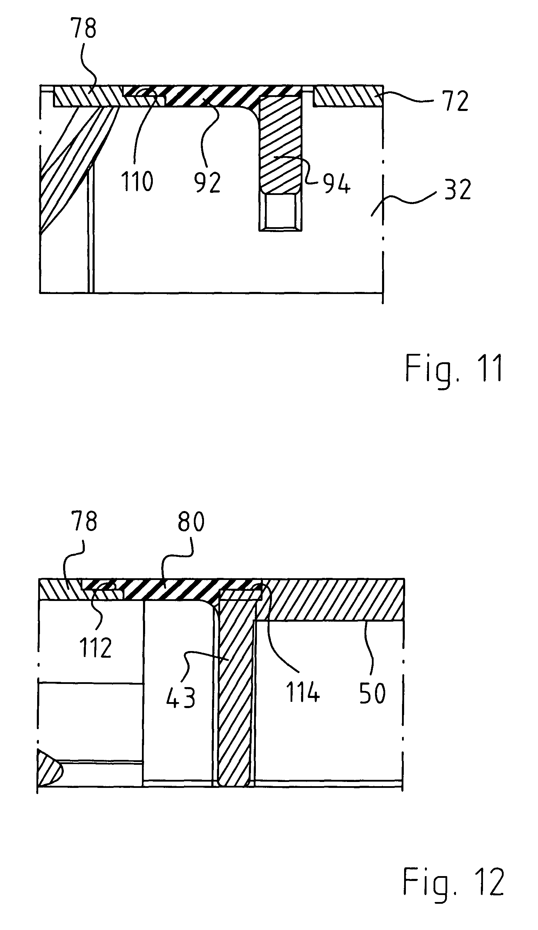

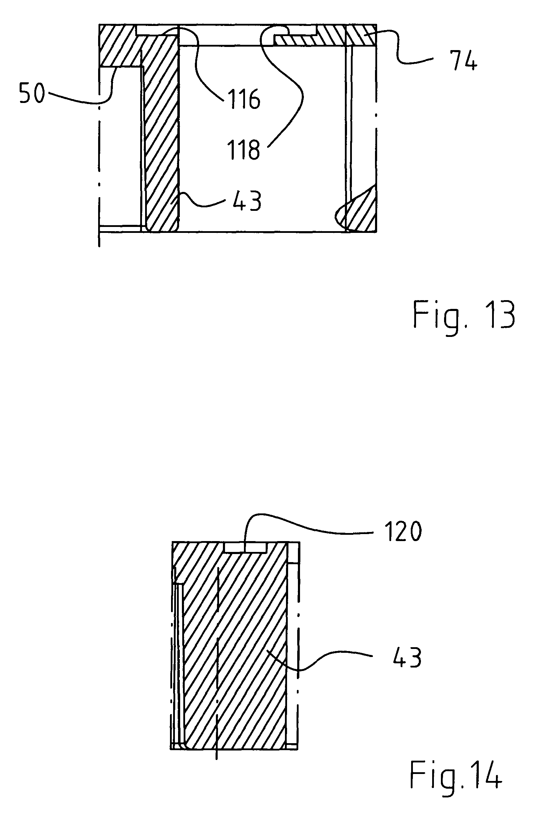

Es ist darauf hinzuweisen, dass die Scharniere der Klappen beim bevorzugten Ausführungsbeispiel als elastische Bänder dargestellt sind, und dass diese Bänder im Schnitt nur in den Fig. 11, 12, 16 und 17 dargestellt sind, während in den Fig. 13, 14 und 18 diese elastischen Bänder nicht dargestellt sind, um das Verständnis zu erleichtern.

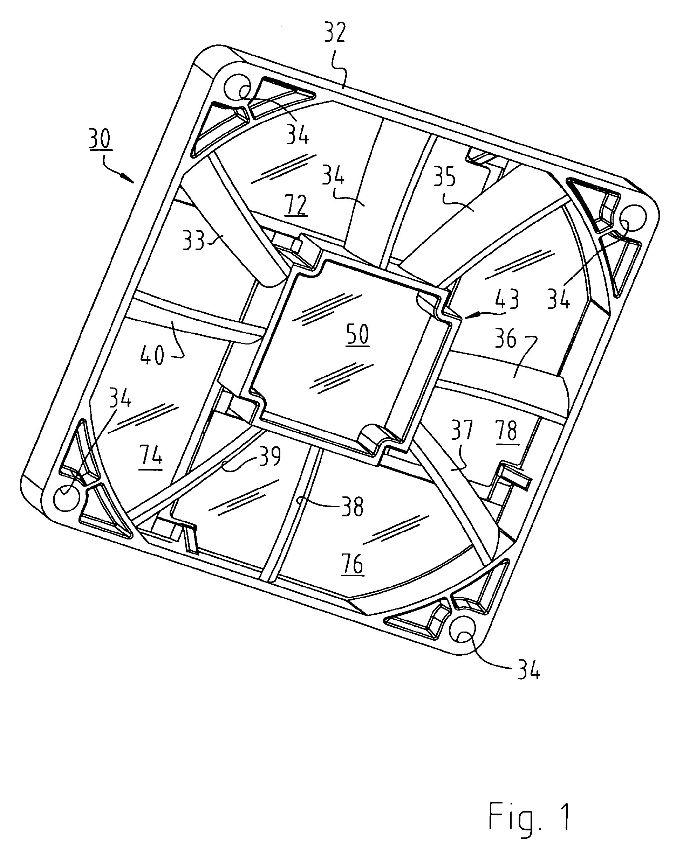

**Fig. 1** zeigt ein Nachleitelement 30 von der Art, wie es bei der Erfindung verwendet werden kann. Naturgemäß können solche Nachleitelemente die verschiedensten Formen haben, d.h. das dargestellte Beispiel stellt zwar die derzeit bekannte beste Ausführungsform dar, kann aber in vielfacher Weise variiert werden. Ein solches Nachleitelement wird oft auch als Nachleitrad bezeichnet.

### Die Funktion eines solchen Nachleitelements ist folgende:

Die Luft, die aus einem Axial- oder Diagonallüfter austritt, hat durch die Drehung des Lüfterrades einen Drall, d.h. sie bewegt sich etwa nach Art eines Korkenziehers. Dieser Drall hat keine nützliche Funktion, erfordert aber Energie zu seiner Erzeugung.

Durch das Nachleitelement wird dieser Drall in einen statischen Druck transformiert, welcher bei einem Lüfter nützlich ist, weil er die Luft durch das zu kühlende Gerät presst.

Das Nachleitelement 30 hat einen äußeren Rahmen 32, der bei der dargestellten Ausführungsform etwa quadratisch ist, aber z.B. auch rund sein könnte. In seinen vier Ecken hat dieser Rahmen 32 vier Montageöffnungen 34 üblicher Art, wie sie von Gerätelüftern bekannt sind. Die Öffnungen 34 dienen zur Montage.

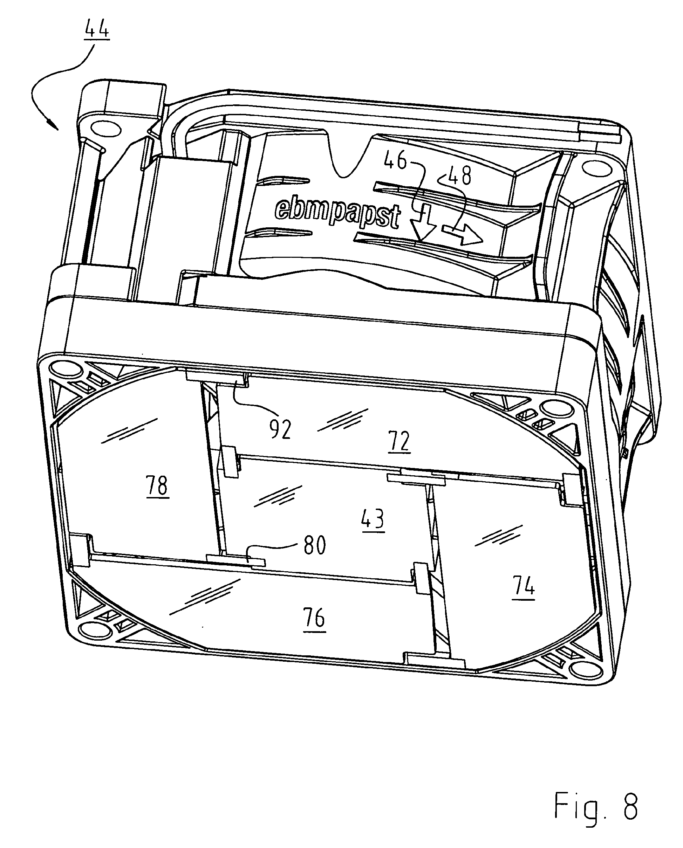

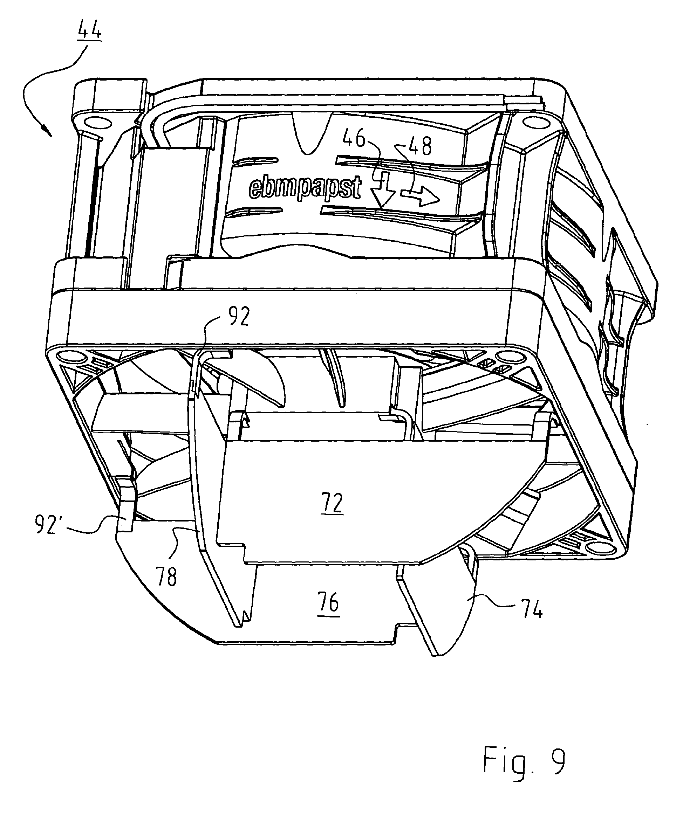

Vom Rahmen 32 gehen in ähnlichen Winkelabständen insgesamt acht Luftleitelemente 33 bis 40 radial nach innen zu einem etwa rechteckförmigen inneren Halteglied 43. Die Luftleitelemente 33 bis 42 haben etwa das gleiche Profil wie die Flügel des zugehörigen Lüfters, also meistens ein Tragflächenprofil, und sie sind so ausgestaltet, dass sie dem Drall der Luftströmung entgegenwirken, die aus dem zugeordneten Lüfter 44 austritt, wie er z.B. in den Fig. 8 und 9 dargestellt ist. In diesen beiden Figuren ist bei 46 die Richtung der Luftströmung und bei 48 die Drehrichtung des Lüfters angegeben. Daraus ergibt sich für den Fachmann die Form des Dralls der Luftströmung, die aus dem Gerätelüfter 44 austritt.

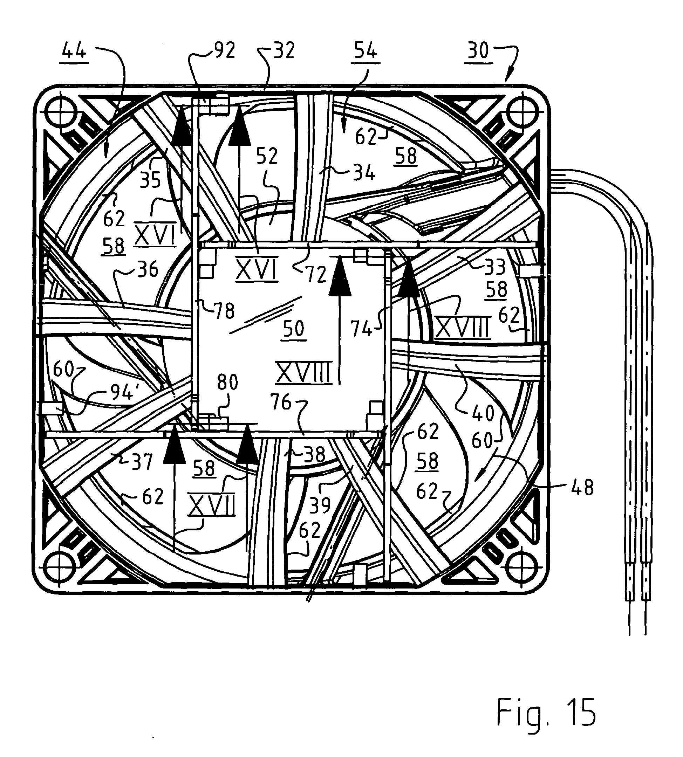

Die Luftleitelemente 33 bis 40 sind bevorzugt einstückig mit dem Rahmen 32 und dem inneren Halteglied 43 ausgebildet, so dass das Halteglied 43 von den Elementen 33 bis 40 gehalten wird. Es hat einen Boden 50 und ist etwa so groß wie die Nabe 52 (Fig. 15) des Lüfterrads 54 des zugeordneten Lüfters 44. Diese Nabe 52 trägt gewöhnlich den (nicht dargestellten) Antriebsmotor für das Lüfterrad 54. In Fig. 15 sind die fünf Flügel 58 des Lüfterrads 54 beispielhaft gezeigt. Dargestellt ist ein Lüfter 44 mit fünf Flügeln 58, deren Vorderseiten 60 sichelförmig ausgebildet sind. Die Flügel 58 haben bevorzugt an ihren radial äußeren Kanten Verbreiterungen 62, welche die Lüftergeräusche reduzieren.

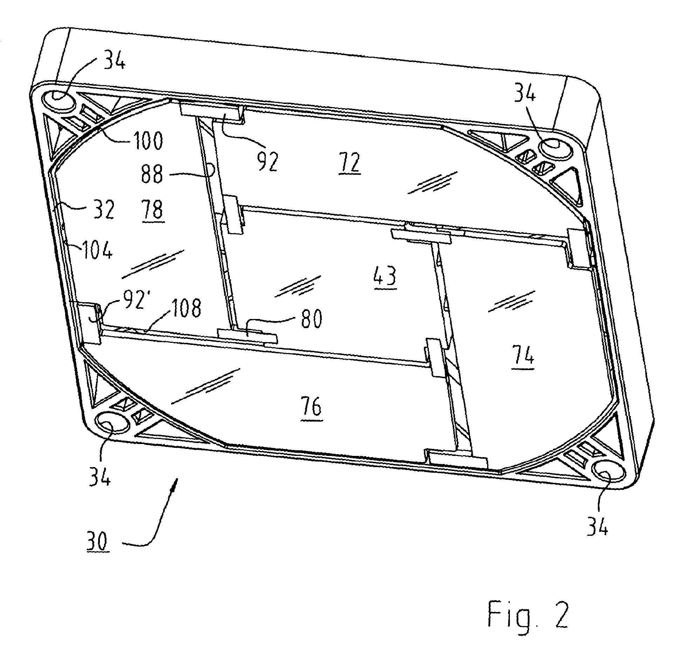

Die Drehrichtung 48 ist auch in Fig. 15 angegeben, d.h. das Lüfterrad 54 dreht sich dort im Uhrzeigersinn und in Richtung zu den konkaven Seiten 62 der radialen Halteglieder 33 bis 40. Letztere definieren zwischen sich Durchströmöffnungen für die vom Lüfter 44 geförderte Luft, z.B. in Fig. 1 die Durchströmöffnung zwischen den Haltegliedern 37 und 38. Wenn ein Lüfter einer Lüfterbatterie defekt wird, müssen diese Durchströmöffnungen durch Schließglieder verschlossen werden. Hierzu sind gemäß Fig. 2 um das innere Halteglied 43 herum vier Rückschlagklappen 72, 74, 76, 78 in symmetrischer Weise angeordnet, und beim Ausführungsbeispiel sind diese vier Klappen identisch ausgebildet. Sie sind - wegen der guten Dämpfung - bevorzugt aus Polypropylen mit Glasfaserverstärkung. Wie Fig. 2 zeigt, liegen die Klappen 72, 74, 76, 78 in ihrer Schließstellung versenkt in der Oberfläche des Nachleitelements 30, so dass sie beim Transport durch den überstehenden äußeren Rand 32 des Nachleitelements 30 geschützt sind.

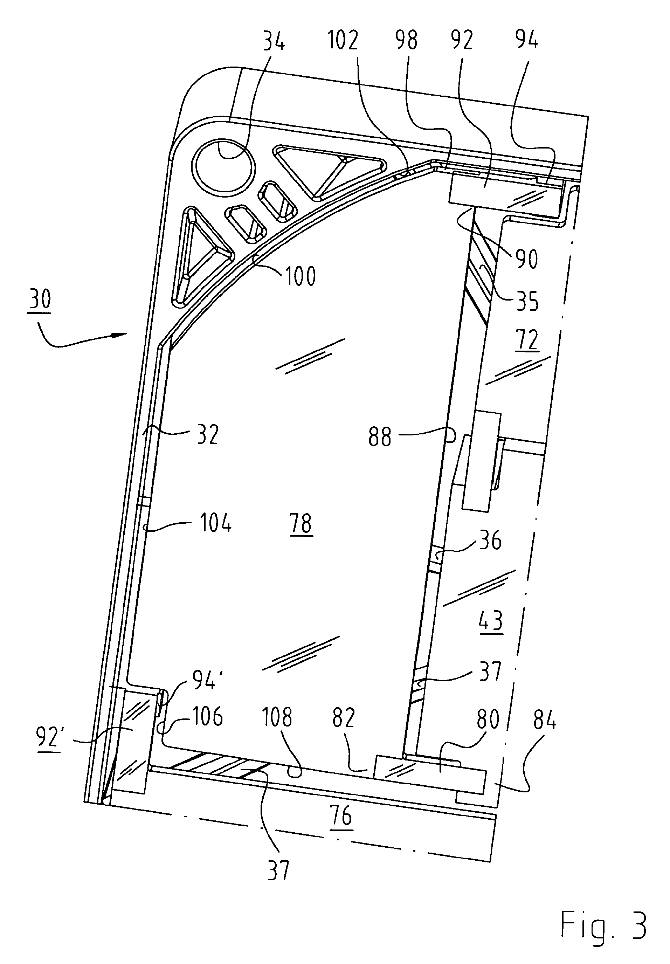

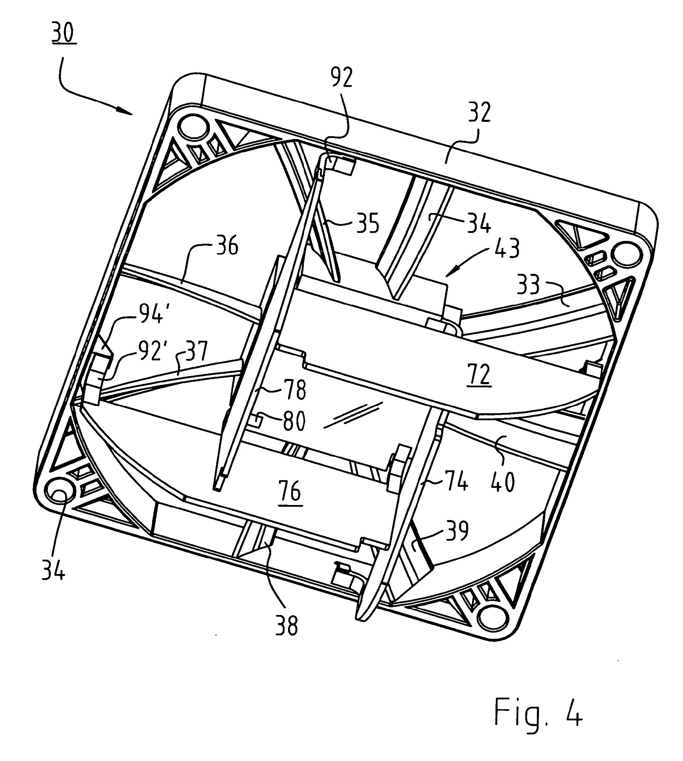

**Fig. 3** zeigt in stark vergrößerter Darstellung die Klappe 78. Diese ist über ein elastisches Band 80 an ihrem radial inneren Eck 82 mit dem in Fig. 3 linken unteren Eck 84 des inneren Halteglieds 43 verbunden. Das elastische Band 80 besteht aus einem elastomeren Kunststoff, bevorzugt aus einem thermoplastischen Elastomer (TPE), dessen Härtegrad entsprechend den Erfordernissen eingestellt ist. Dieses Band 80 aus TPE ist an das Eck 82 der Klappe 78 und an das Eck 84 des inneren Halteglieds 43 angespritzt, also durch Anschmelzen mit der Klappe 78 und dem Halteglied 43 verbunden. Der Spritzvorgang erfolgt, während sich die Klappe 78 in ihrer Schließstellung befindet, wie sie in Fig. 3 dargestellt ist. Wenn also die Klappen 72, 74, 76, 78 geöffnet sind, wie das in Fig. 4 dargestellt ist, wirkt auf sie von den Bändern aus TPE eine Rückstellkraft, welche bestrebt ist, sie in die Schließstellung zu drehen.

Wie Fig. 3 zeigt, hat die Klappe 78 eine innere Kante 88, welche gerade ist und an deren in Fig. 3 oberem Ende 90 ebenfalls ein Band 92 aus TPE angespritzt ist, dessen in Fig. 3 rechtes Ende an einem Vorsprung 94 angespritzt ist, der vom Rand 32 nach innen ragt, und dessen in Fig. 3 linkes Ende an das rechte obere Ende 90 der Klappe 78 angespritzt ist. Dadurch kann die Klappe 78 in Fig. 3 von links nach rechts in eine etwa senkrechte Lage verschwenkt werden, wie sie in Fig. 4 dargestellt ist. Dasselbe gilt - wegen der identischen Form und der identischen Befestigung - für die anderen Klappen 72, 74 und 76.

Im Anschluss an die gerade Kante 88, und unter einem rechten Winkel zu ihr, hat die Klappe 78 oben einen kurzen geraden Abschnitt 98, und daran anschließend einen kreisbogenförmigen Abschnitt 100, der komplementär zum gegenüberliegenden Rand 102 des Nachleitelement 30 verläuft. Der Abschnitt 100 geht in Fig. 3 nach unten über in einen geraden Rand 104, der parallel zum Rand 88 verläuft, und der Rand 104 erstreckt sich bis zu einer Aussparung 106 am linken unteren Eck der Klappe 78. Von dieser Aussparung 106 verläuft in Fig. 3 eine gerade untere Kante 108 waagerecht bis zum Eck 82. Die Klappe 78 hat also etwa die Umrissform eines Rechtecks, bei dem das linke obere Eck abgeschnitten ist.

In der Aussparung 106 befindet sich, wie dargestellt, ein Vorsprung 94' des Rahmens 32, und an diesem Vorsprung 94' ist, wie dargestellt, ein elastisches Band 92' für die Klappe 76 angespritzt.

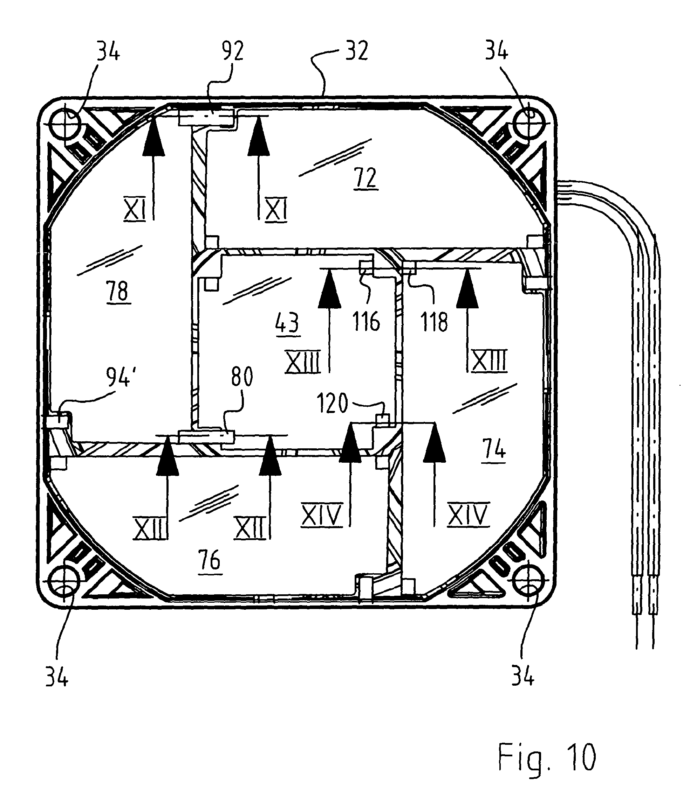

**Fig. 11** zeigt einen Schnitt, gesehen längs der Linie XI-XI der Fig. 10 durch das elastische Gelenkband 92 aus TEP. Dieses ist einerseits mit einem Pfosten 94 aus Kunststoff verbunden, z.B. aus glasfaserverstärktem Polypropylen, und es ist mit diesem Pfosten durch Anschmelzen verbunden. Andererseits ist es mit der Klappe 78 (ebenfalls aus Polypropylen) verbunden, die zu diesem Behuf mit einer Aussparung 110 versehen ist, die vom TEP des Bandes 92 ausgefüllt ist. Das Band 92 erstreckt sich wie dargestellt auch über die Oberseite des Pfostens 94, um eine besonders dauerhafte Verbindung zu erhalten.

**Fig. 12** zeigt einen Schnitt, gesehen längs der Linie XII-XII der Fig. 10. Links ist die Klappe 78, die eine Aussparung 112 hat, mit welcher das linke Ende des elastischen Gelenkbands 80 durch Anschmelzen verbunden ist. Rechts befindet sich das innere Halteglied 43, das an seiner Oberseite eine Aussparung 114 hat, mit welcher das rechte Ende des Gelenkbands 80 ebenfalls durch Anschmelzen verbunden ist.

**Fig. 13** zeigt einen Schnitt, gesehen längs der Linie XIII-XIII der Fig. 10. Das elastische Gelenkband ist hier nicht eingezeichnet, sondern nur die entsprechende Aussparung 116 an der Oberseite des inneren Halteglieds 43, und eine Aussparung 118 an der Klappe 74. Die Teile werden in der Anordnung gemäß Fig. 13 in eine (nicht dargestellte) Spritzgussform eingelegt, und dort wird das gelenkige Band aus TPE eingespritzt, das spiegelbildlich aussieht wie das Band 80 der Fig. 12 und deshalb nicht dargestellt ist.

**Fig. 14** zeigt einen Schnitt, gesehen längs der Linie XIV-XIV der Fig. 10. Das elastische Glied ist hier nicht eingezeichnet, sondern nur eine Ausnehmung 120 des inneren Halteglieds 43, in welcher dieses elastische Glied durch einen Spritzgussvorgang verankert wird.

**Fig. 15** ist eine Darstellung analog Fig. 10, bei der aber die Klappen 72, 74, 76, 78 in ihrer geöffneten Stellung dargestellt sind, die sie einnehmen, wenn der Lüfter 44 in Betrieb ist, weshalb dann die elastischen Gelenkbänder 80, 92 etc. um etwa 90° abgebogen sind und eine entsprechende Rückstellkraft auf die Rückstellklappen 72, 74, 76, 78 ausüben. Es sind nur zwei der insgesamt acht Gelenkbänder dargestellt.

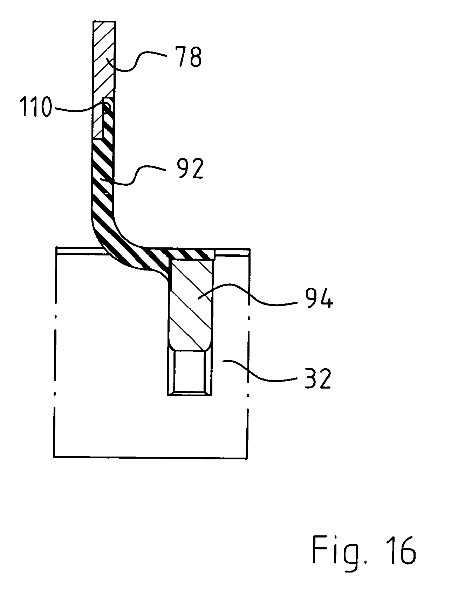

**Fig. 16** zeigt einen Schnitt XVI-XVI der Fig. 15. Dieser entspricht - bei geschlossener Klappe - dem Schnitt gemäß Fig. 11. Die Bezugszeichen sind die gleichen wie in Fig. 11, weshalb hierauf verwiesen wird.

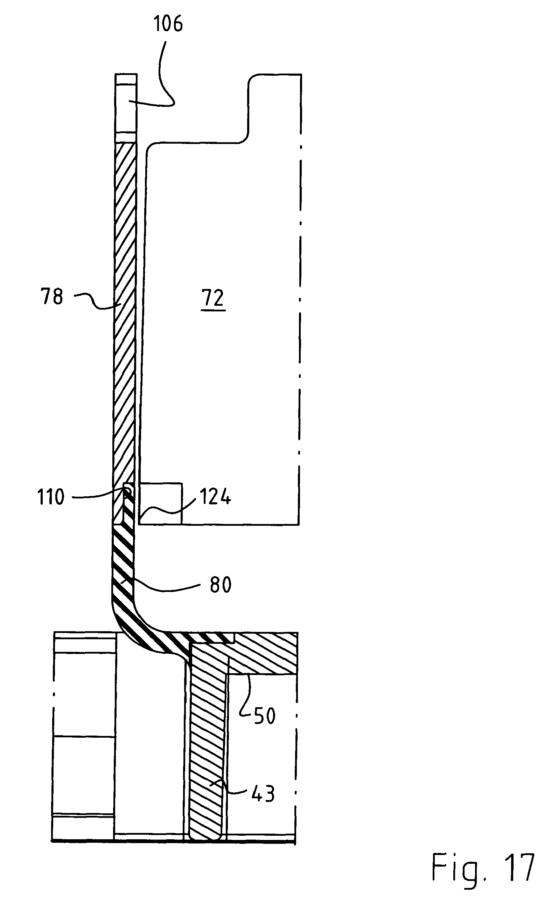

**Fig. 17** zeigt einen Schnitt, gesehen längs der Linie XVII-XVII der Fig. 15. Dieser Schnitt entspricht Fig. 12 mit dem Unterschied, dass in Fig. 12 die Klappe 78 geschlossen und in Fig. 17 geöffnet ist. Die Bezugszeichen sind in beiden Figuren dieselben. Fig. 17 zeigt, dass die zur Klappe 78 benachbarte Klappe 72 im geöffneten Zustand mit ihrem unteren linken Eck 124 gegen das TPE-Material des Gelenkbandes 80 stößt, wodurch ein Klappern vermieden wird. Dies gilt - wegen der Symmetrie der Anordnung - in gleicher Weise für alle Klappen des Nachleitelements 30, weshalb dieses auch als super-silent bezeichnet werden kann.

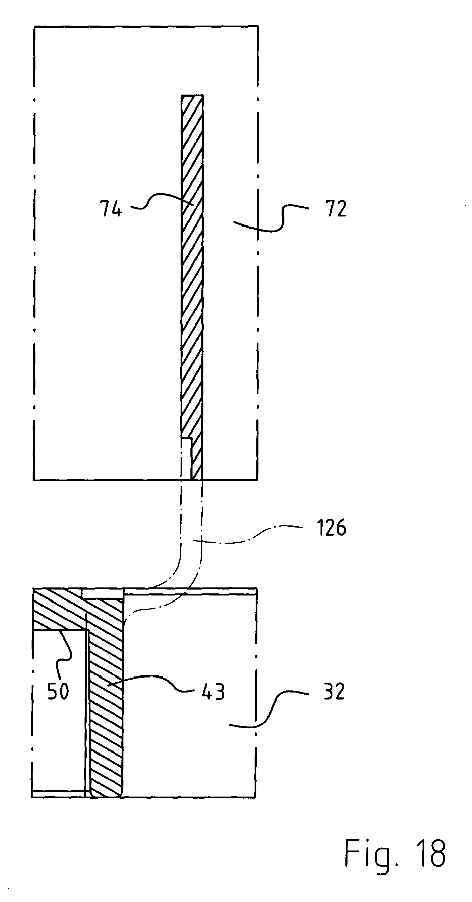

**Fig. 18** zeigt einen Schnitt, gesehen längs der Linie XVIII-XVIII der Fig. 15, also bei geöffneter Klappe 74. Das Gelenkband 126 ist mit strichpunktierten Linien angedeutet, aber nicht dargestellt.

Durch die vorliegende Erfindung erhält man also verschiedene vorteilhafte Wirkungen.

Da das Nachleitelement 30 mit den Rückschlagklappen 72, 74, 76, 78 zu einer Baueinheit zusammengefasst ist, kann man diese Baueinheit bei Bedarf mit einem beliebigen Lüfter 44 der gleichen Baugröße kombinieren, wie das z.B. in Fig. 8 und 9 dargestellt ist, wodurch sich der Preis des Lüfters 44 nur unwesentlich erhöht. Alternativ kann man das Nachleitelement 30 auch fest mit dem Lüfter 44 verbinden, wenn sich von den Stückzahlen her hierfür eine Motivation ergibt.

Das Nachleitelement baut einen zusätzlichen statischen Druck auf, wodurch zumindest ein Teil des durch die Klappen 72, 74, 76, 78 verursachten Druckverlusts ausgeglichen wird.

Die Klappen können in einfacher Weise über die Anbindungselemente aus TPE an das Nachleitelement 30 angespritzt werden. Alternativ können die Klappen komplett aus TPE ausgebildet werden, wobei sie dann keine speziellen Anbindungselemente benötigen.

Man erhält eine sehr kostengünstige Lösung, da das Nachleitelement zusammen mit seinen Klappen komplett in einem Spritzgießprozess herstellbar ist. Dadurch entfällt die Notwendigkeit, Einzelteile, z.B. Federn, manuell zu montieren.

Ein solches Nachleitelement funktioniert unabhängig von seiner Lage, was für die Praxis ein wichtiger Vorteil ist.

Da der Härtegrad des TPE-Materials einstellbar ist, kann die Steifigkeit der Anbindungselemente eingestellt werden. Dies ermöglicht es, das Nachleitelement je nach Luftleistung zu verändern, d.h. bei einer geringen Luftleistung wird man Anbindungselemente verwenden, die nur eine geringe Steifigkeit haben, während man für hohe Luftleistungen entsprechend steife Anbindungselemente verwenden kann.

Ein erfindungsgemäßes Nachleitelement einschließlich seiner Klappen benötigt nur einen kleinen Bauraum, und es verursacht nur ein geringes Geräusch, da man Kunststoffe mit hoher Eigendämpfung verwenden kann.

Ein solches Nachleitelement ist einfach an Axiallüfter und Diagonallüfter adaptierbar.

Das den Rückschlagklappen vorgeschaltete Nachleitelement bewirkt eine drallarme Anströmung dieser Klappen. Dadurch neigen diese erheblich weniger zum Schwingen/Flattern.

Die angespritzten Klappenanschläge verhindern, dass sich die Klappen berühren bzw. verhaken und damit gegenseitig behindern. Dies ist für die Praxis ein wichtiger Vorteil.

Von Vorteil ist auch, dass die Nachleitelemente vom Kunden in der gewünschten Stückzahl bestellt werden können, und dass es sehr einfach ist, einige Reserve-Nachleitelemente auf Lager zu halten und bei Bedarf defekte Nachleitelemente durch solche Reserveteile zu ersetzen, ohne dass man den kompletten Lüfter ersetzen muss.

Naturgemäß sind im Rahmen der vorliegenden Erfindung vielfache Abwandlungen und Modifikationen möglich.

## Patentansprüche

1. Lüfter (44) nach Art eines Axial- oder Diagonallüfters,
mit einem Lüftergehäuse, das eine Lufteintrittsöffnung und eine Luftaustrittsöffnung aufweist,
mit einem im Bereich der Luftaustrittsöffnung vorgesehenen Nachleitelement (30),
- welches dazu ausgebildet ist, den Drall der im Betrieb aus dem Lüfter (44) austretenden Luft mindestens teilweise in statischen Druck umzusetzen,
- welches mindestens eine Luftdurchtrittsöffnung aufweist, und
- welches an der Ausströmseite dieser Luftdurchtrittsöffnung mit mindestens einer Rückschlagklappe (72, 74, 76, 78) versehen ist, welche in ihrer Schließstellung die Luftdurchtrittsöffnung mindestens teilweise verschließt.

2. Lüfter nach Anspruch 1, bei welchem der mindestens einen Rückschlagklappe (72, 74, 76, 78) ein elastisches Glied (80, 92) zugeordnet ist, welches diese Klappe (72, 74, 76, 78) in Richtung auf ihre Schließstellung beaufschlagt.

3. Lüfter nach Anspruch 1 oder 2, bei welchem die mindestens eine Rückschlagklappe (72, 74, 76, 78) über mindestens ein elastisches Glied (80, 92) am Nachleitelement (30) angelenkt ist, welches elastische Glied diese Klappe (72, 74, 76, 78) in Richtung auf ihre Schließstellung beaufschlagt.

4. Lüfter nach einem der vorhergehenden Ansprüche, bei welchem das Nachleitelement (30) in einem zentralen Bereich ein Halteglied (43) aufweist, das von Luftdurchtrittsöffnungen für die aus dem Lüfter (44) austretende Luftströmung umgeben ist.

5. Lüfter nach Anspruch 4, bei welchem das Nachleitelement (30) Eckbereiche aufweist, und sich mindestens eine Rückschlagklappe (72, 74, 76, 78) im geschlossenen Zustand vom Halteglied (43) bis zu einem Eckbereich des Nachleitelements (30) erstreckt.

6. Lüfter nach Anspruch 4 oder 5, bei welchem an einem radial äußeren Bereich des Nachleitelements (30) mindestens eine äußere Klappe angelenkt ist, welche mit einer am Halteglied (43) angelenkten inneren Klappe zusammenwirkt, um im geschlossenen Zustand beider Klappen eine diesen zugeordnete Luftdurchtrittsöffnung des Nachleitelements (30) zu verschließen.

7. Lüfter nach einem der Ansprüche 4 bis 6, bei welchem eine Rückschlagklappe (72, 74, 76, 78) zusätzlich zur Anlenkung am Halteglied (43) auch eine Anlenkung an einem Randbereich (32) des Nachleitelements (30) aufweist.

8. Lüfter nach Anspruch 7, bei welchem eine Anlenkstelle (92) zur Anlenkung im Randbereich (32) des Nachleitelements (30) vorgesehen ist, welche Anlenkstelle (92) einer vorgegebenen Klappe (72, 74, 76, 78) zugeordnet ist und in einem Bereich liegt, der bei geschlossenen Klappen (72, 74, 76, 78) durch eine Ausnehmung einer zur vorgegebenen Rückschlagklappe benachbarten Rückschlagklappe ragt.

9. Lüfter nach einem der vorhergehenden Ansprüche, bei welchem sich die Klappen (72, 74, 76, 78) im geöffneten Zustand weg vom Gerätelüfter (44) erstrecken.

10. Lüfter nach einem der vorhergehenden Ansprüche, bei welchem eine Rückschlagklappe (72, 74, 76, 78) am Nachleitelement (30) mittels eines Elastomers (80, 92) angelenkt ist, welches dazu ausgebildet ist, die an ihm angelenkte Rückschlagklappe (72, 74, 76, 78) bei fehlender Luftströmung in ihre Schließstellung zu bewegen.

11. Lüfter nach Anspruch 10, bei welchem das Elastomer (80. 92) durch Kunststoffspritzguss (molding) an mindestens einem Element der von Rückschlagklappe (72, 74, 76, 78) und Nachleitelement (30) gebildeten Menge befestigt ist.

12. Lüfter nach Anspruch 10 oder 11, bei welchem das Elastomer nach Art eines flexiblen Bandes (80, 92) ausgebildet ist.

13. Lüfter nach einem der vorhergehenden Ansprüche, bei welchem das Nachleitelement (30) eine Mehrzahl von stationären Luftleitschaufeln (33 bis 40) aufweist, welche sich zwischen einem zentralen Halteglied (43) und einem diesen umgebenden Rahmen (32) des Nachleitelements (30) erstrecken und als Trageglieder für das zentrale Halteglied (43) ausgebildet sind.

14. Lüfter nach einem der vorhergehenden Ansprüche, bei welchem das Gehäuse des Nachleitelements (30) einstückig mit dem Gehäuse des Gerätelüfters (44) ausgebildet ist.

15. Lüftereinschub, in welchem eine Mehrzahl von Lüftern nach mindestens einem der vorhergehenden Ansprüche angeordnet ist.
